(19) Europäisches Patentamt
European Patent Office
Office européen des brevets

(11) Veröffentlichungsnummer : **0 083 627
B1**

(12) **EUROPÄISCHE PATENTSCHRIFT**

(45) Veröffentlichungstag der Patentschrift :
30.10.85

(51) Int. Cl.⁴ : **H 01 L 31/02, H 01 L 33/00**

(21) Anmeldenummer : 82902254.0

(22) Anmeldetag : 16.07.82

(86) Internationale Anmeldenummer :
PCT/EP 82/00153

(87) Internationale Veröffentlichungsnummer :
WO/8300408 (03.02.83 Gazette 83/04)

(54) OPTO-ELEKTRONISCHES BAUELEMENT.

(30) Priorität : 16.07.81 DE 3128187

(43) Veröffentlichungstag der Anmeldung :
20.07.83 Patentblatt 83/29

(45) Bekanntmachung des Hinweises auf die Patenterteilung : 30.10.85 Patentblatt 85/44

(84) Benannte Vertragsstaaten :
AT BE CH DE FR GB LI NL SE

(56) Entgegenhaltungen :
CA-A- 1 016 679
DE-A- 2 227 322
DE-A- 2 650 770
FR-A- 1 490 665
GB-A- 1 258 660
GB-A- 1 440 274
GB-A- 2 002 959
US-A- 3 911 430
US-A- 4 168 102

(73) Patentinhaber : Sieg, Joachim
Königsberger Str. 18
8068 Pfaffenhofen (DE)

(72) Erfinder : Sieg, Joachim
Königsberger Str. 18
8068 Pfaffenhofen (DE)

(74) Vertreter : Tetzner, Volkmar, Dr.-Ing. Dr. Jur.
Van-Gogh-Strasse 3
D-8000 München 71 (DE)

**Beschreibung**

Die Erfindung betrifft ein opto-elektronisches Bauelement entsprechend dem Oberbegriff des Anspruches 1.

Ein opto-elektronisches Bauelement der im Oberbegriff des Anspruches 1 vorausgesetzten Art ist durch die US-A-4 168 102 bekannt. Der opto-elektronische Halbleiterkörper ist hierbei auf einem Träger aus Kunststoffmaterial angeordnet. Die Anschlüsse sind durch Bohrungen des Kunststoffträgers zur Unterseite hindurchgeführt. Ein auf den Träger aufgesetzter Reflektor aus Kunststoff ist mit einer den opto-elektronischen Halbleiterkörper aufnehmenden Ausnehmung versehen, die an der Oberseite durch einen ebenen, lichtdurchlässigen Film abgeschlossen ist.

Durch die DE-A-2 227 322 und die US-A-3 911 430 sind ferner opto-elektronische Bauelemente bekannt, bei denen die Anschlüsse während des Aufbringens des Halbleiterkörpers und der Bonddrahtverbindung in sogenannter « lead-frame-Technik » zusammengehalten werden (vgl. etwa Fig. 5 der US-A-3 911 430). Erst nach Herstellung der Bonddrahtverbindung werden der Halbleiterkörper, der Bonddraht und Teile der Anschlüsse mit Kunststoff, wie Epoxydharz, umgossen.

Durch die GB-A-1 258 660 ist schließlich ein Transferpapier für gedruckte Schaltungen oder integrierte Schaltkreise bekannt, bei dem eine gedruckte Schaltung mit einer Vielzahl von Anschlüssen mittels des Transferpapieres so auf einen Substrat aufgebracht wird, daß die Anschlüsse von der Oberseite über die Stirnseiten des Substrates zur Unterseite geführt sind. Auf die Anschlüsse auf der Oberseite wird dann ein Halbleiterchip in sog. « face-down-bond »-Bauweise aufgesetzt, während die Anschlüsse an der Unterseite des Substrates in Verbindung mit einer gedruckten Schaltungsplatte gebracht werden.

Der Erfindung liegt die Aufgabe zugrunde, ein opto-elektronisches Bauelement der im Oberbegriff des Anspruches 1 vorausgesetzten Art weiterzuentwickeln.

Diese Aufgabe wird erfindungsgemäß durch die kennzeichnenden Merkmale des Anspruches 1 gelöst.

Zweckmäßige Ausgestaltungen der Erfindung sind Gegenstand der Unteransprüche.

Ein Anwender der erfindungsgemäßen opto-elektronischen Bauelemente kann diese Bauelemente in der von ihm gewünschten Anordnung beispielsweise auf eine gedruckte Schaltungsplatte aufsetzen und durch einen einfachen Löt- oder Klebvorgang anschließen. Er kann auf diese Weise selbst komplizierteste Display-Anordnungen, die eventuell nur in vergleichsweise geringen Stückzahlen benötigt werden, mühelos zusammenstellen.

Ein Ausführungsbeispiel der Erfindung ist in der Zeichnung veranschaulicht. Es zeigen

Figur 1 eine Seitenansicht eines Ausführungsbeispieles des erfindungsgemäßen opto-elektronischen Bauelementes,

Figur 2 eine Aufsicht auf das Bauelement gemäß Fig. 1,

Figur 3 bis 6 Schemadarstellungen einiger Anwendungsmöglichkeiten des erfindungsgemäßen Bauelementes.

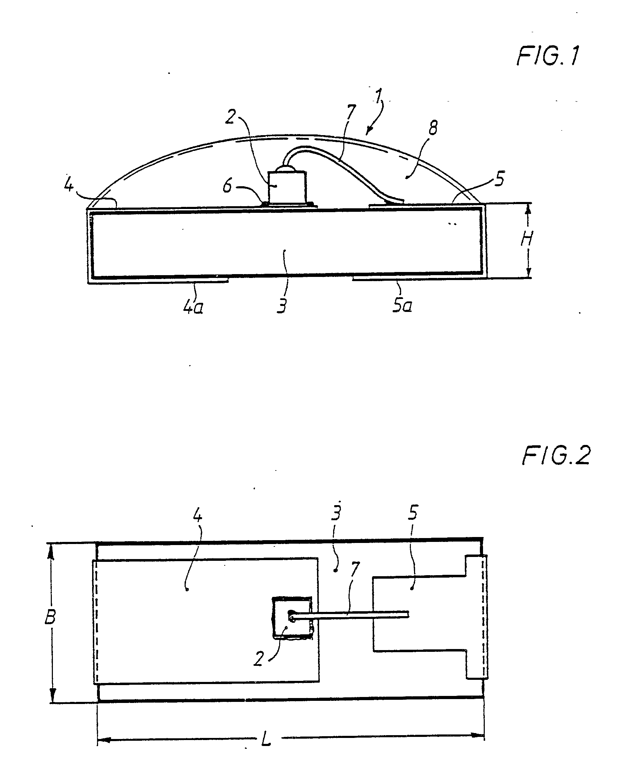

Das in den Fig. 1 und 2 dargestellte opto-elektronische Bauelement 1 enthält einen opto-elektronischen Halbleiterkörper 2 (z. B. ein LED), einen aus Keramik bestehenden Träger 3, zwei auf dem Träger 3 flächig aufgebrachte Anschlüsse 4 und 5, die sich von der den Halbleiterkörper 2 tragenden Breitseite des Trägers erstrecken und dort je eine Anschlußkontaktfläche 4a bzw. 5a bilden.

Die Unterseite des Halbleiterkörpers 2 ist durch einen leitenden Kleber 6 flächig mit dem Anschluß 4 verbunden. Die Oberseite des Halbleiterkörpers 2 steht über einen Verbindungsdraht, den sog. Bonddraht 7, mit dem anderen Anschluß 5 in Verbindung.

Der Halbleiterkörper 2 ist erhaben auf der oberen Breitseite des Trägers 3 angeordnet. Eine lichtdurchlässige, aus Epoxydharz bestehende Schicht 8 deckt die ganze, den Halbleiterkörper 2 tragende Breitseite des Trägers 3 ab und schützt damit den Halbleiterkörper 2, den Bonddraht 7 sowie die Anschlüsse 4 und 5.

Der Träger 3 ist quaderförmig ausgebildet. Seine Breite B beträgt maximal 1,27 mm und entspricht damit dem Rastermaß (1/10") üblicher gedruckter Schaltungen. Die Länge L des Trägers 3 beträgt beim dargestellten Ausführungsbeispiel etwa 3,2 mm, die Höhe H etwa 0,6 mm.

Die den Halbleiterkörper 2 abdeckende Schicht 8 aus Epoxydharz ist domartig gewölbt. Sie kann entweder farblos-lichtdurchlässig oder farbig sein. Je nach dem Anwendungszweck kann es ferner erwünscht sein, der Schicht 8 lichtstreuende Eigenschaften zu geben.

Die beiden Anschlüsse 4 und 5 können eine unterschiedliche Länge erhalten, um dem Anwender eine zuverlässige Unterscheidung zu ermöglichen.

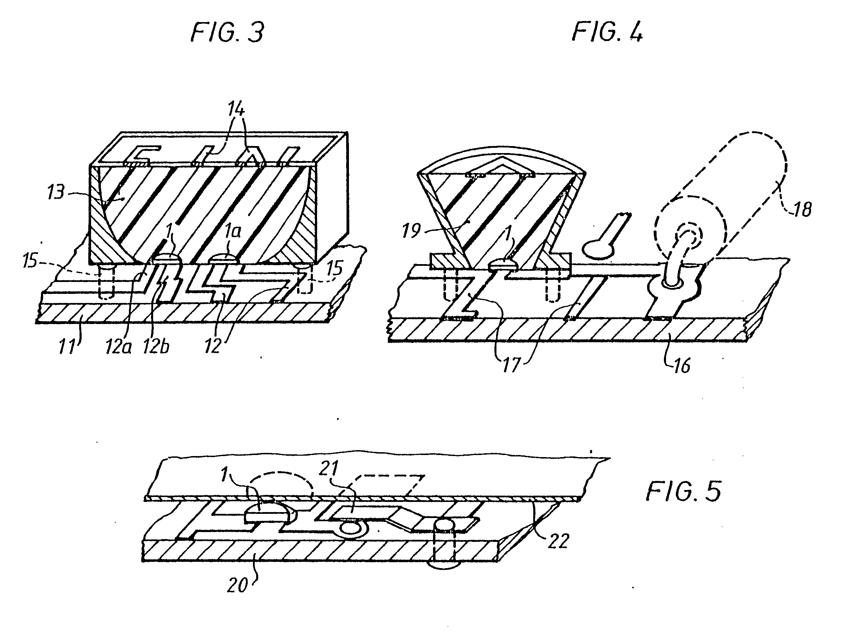

Die Fig. 3 bis 6 veranschaulichen einige Möglichkeiten zur Anwendung des erfindungsgemäßen Bauelementes.

Fig. 3 zeigt einen Teil einer Leiterplatte 11 mit aufgedruckten Leiterbahnen 12, auf die zwei opto-elektronische Bauelemente 1 und 1a aufgesetzt sind. Im Falle des Bauelementes 1 steht somit die Anschlußkontaktfläche 4a (vgl. Fig. 1) beispielsweise in Verbindung mit der Leiterbahn 12a und die Anschlußkontaktfläche 5a (Fig. 1) in Verbindung mit der Leiterbahn 12b. Die Herstellung dieser Anschlußverbindung zwischen den Bauelementen 1, 1a und den Leiterbahnen 12 erfolgt in üblicher Weise durch Löten oder mittels eines Leitklebers.

Über den beiden opto-elektronischen Bauelementen 1, 1a ist ein Reflektor 13 angeordnet, der an seiner Oberseite beispielsweise eine Beschriftung 14 trägt. Der Reflektor 13 ist beim dargestellten Ausführungsbeispiel mit Steckerstiften 15 auf der Leiterplatte 11 befestigt.

Fig. 4 zeigt ein anderes Ausführungsbeispiel einer Leiterplatte 16 mit darauf vorgesehenen Leiterbahnen 17 und elektrischen Bauteilen 18. An einer Stelle des dargestellten Ausschnittes der Leiterplatte ist ein erfindungsgemäßes opto-elektronisches Bauelement 1 vorgesehen, über dem ein Reflektor 19 angebracht ist.

Bei dem Ausführungsbeispiel gemäß Fig. 5 trägt die Leiterplatte 20 u. a. einen Drucktaster 21 und ein opto-elektronisches Bauelement 1. Über der Leiterplatte 20 und den von ihr getragenen Bauteilen ist eine Abdeckfolie 22 vorgesehen.

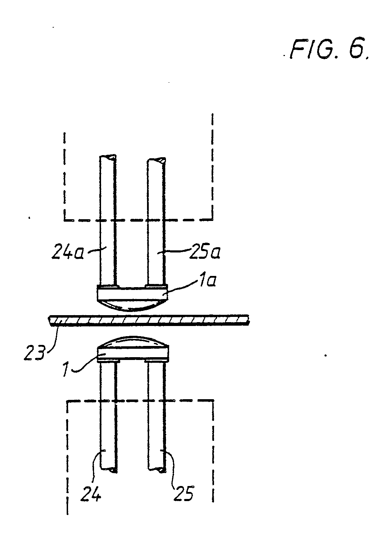

Fig. 6 zeigt in ganz schematischer Form eine Einrichtung zum Lesen eines Lochstreifens bzw. einer Lochscheibe 23. Auf der einen Seite ist als Sender ein Licht emittierendes Bauelement 1 und auf der anderen Seite als Empfänger ein licht- empfindliches Bauelement 1a vorgesehen. Diese beiden Bauelemente sind hier mit ihren Anschlußkontaktflächen (z. B. 4a, 5a, vgl. Fig. 1) auf Metallstifte 24, 25 bzw. 24a, 25a aufgesetzt und hiermit verlötet bzw. leitend verklebt.

Der Träger 3 muß nicht exakt quaderförmig sein, sondern kann beispielsweise an den beiden Stirnseiten Einbuchtungen aufweisen, durch die die Anschlüsse von der einen zur anderen Außenfläche verlaufen.

## Patentansprüche

1. Opto-elektronisches Bauelement, enthaltend

a) einen opto-elektronischen Halbleiterkörper (2),

b) einen aus Isoliermaterial bestehenden Träger (3), auf dessen Oberseite der Halblei- terkörper (2) erhaben angeordnet ist,

c) zwei auf der Oberseite des Trägers (3) flächig angeordnete Anschlüsse (4, 5), von denen der eine mit der Unterseite des Halbleiterkörpers (2) und der andere über einen Bonddraht (7) mit der Oberseite des Halbleiterkörpers (2) verbunden ist und die beide mit Anschlußkontaktelementen (4a, 5a) an der Unterseite des Trägers (3) in Verbindung stehen,

d) eine über dem Halbleiterkörper (2) angeordnete lichtdurchlässige Schicht (8), gekennzeichnet durch folgende Merkmale :

e) der Träger (3) besteht aus Keramikmaterial ;

f) die beiden Anschlüsse (4, 5) erstrecken sich von der Oberseite des Trägers (3) über die beiden Stirnseiten des Trägers (3) hinweg zur Unterseite und bilden dort die als Kontaktflächen an der Unterseite des Trägers (3) anliegenden Anschlußkontaktelemente (4a, 5a) ;

g) die aus Epoxydharz bestehende lichtdurchlässige Schicht (8) ist mit domartiger Wölbung auf die den Halbleiterkörper (2) tragende Breitseite des Trägers (3) aufgebracht.

2. Bauelement nach Anspruch 1, dadurch gekennzeichnet, daß der im wesentlichen qua- derförmige Träger (3) eine Breite von maximal 1,27 mm aufweist.

3. Bauelement nach Anspruch 2, dadurch gekennzeichnet, daß der Träger (3) eine Länge von 3,2 mm, eine Breite von 1,27 mm und eine Höhe von 0,6 mm aufweist.

4. Bauelement nach Anspruch 1, dadurch gekennzeichnet, daß die lichtdurchlässige Schicht (8) die ganze den Halbleiterkörper (2) tragende Breitseite des Trägers (3) abdeckt.

5. Bauelement nach Anspruch 1, dadurch gekennzeichnet, daß die lichtdurchlässige Schicht (8) farbig ist.

6. Bauelement nach Anspruch 1, dadurch gekennzeichnet, daß die lichtdurchlässige Schicht (8) lichtstreuende Eigenschaften besitzt.

7. Bauelement nach Anspruch 1, dadurch gekennzeichnet, daß die beiden Anschlüsse (4, 5) eine unterschiedliche Länge aufweisen.

8. Bauelement nach Anspruch 1, dadurch gekennzeichnet, daß der Träger (3) an den beiden Stirnseiten Einbuchtungen aufweist, durch die die Anschlüsse (4, 5) von der Oberseite zur Unterseite des Trägers verlaufen.

## Claims

1. Opto-electronic component, comprising

a) an opto-electronic semiconductor body (2),

b) a carrier (3) made from insulating material, the semiconductor body (2) being arranged raised on the upper side of the carrier,

c) two terminals (4, 5) which are applied flat to the upper side of the carrier (3), one terminal being connected with the lower side of the semiconductor body (2) and the other terminal being connected with the upper side of the semiconductor body (2) via a bonding wire (7), both terminals being connected with terminal contact elements (4a, 5a) on the lower side of the carrier (3),

d) a light-permeable layer (8) covering the semiconductor body (2), characterised by the following features :

e) the carrier (3) is made from ceramic material ;

f) both terminals (4, 5) extend from the upper side of the carrier (3) via both front sides of the carrier (3) to the lower side and there form the terminal contact elements (4a, 5a) which adjoin the lower side of the carrier (3) as contact surfaces ;

g) the light-permeable layer (8) made of epoxy resin is curved like a dome and applied to that broadside of the carrier (3) supporting the semiconductor body (2).

2. Component as claimed in claim 1, characterised in that the substantially square carrier (3) has a width of at most 1,27 mm.

3. Component as claimed in claim 2, characterised in that the carrier (3) has a length of 3,2 mm, a width of 1,27 mm and a height of 0,6 mm.

4. Component as claimed in claim 1, characterised in that the light-permeable layer (8) covers the whole broadside of the carrier (3) supporting the semiconductor body (2).

5. Component as claimed in claim 1, characterised in that the light-permeable layer (8) is coloured.

6. Component as claimed in claim 1, characterised in that the light-permeable layer (8) has light-diffusing properties.

7. Component as claimed in claim 1, characterised in that both terminals (4, 5) are of different length.

8. Component as claimed in claim 1, characterised in that the carrier (3) comprises recesses on the two bond sides through which the terminals (4, 5) extend from the upper side to the lower side of the carrier.

**Revendications**

1. Composant opto-électronique comprenant :

a) un corps semi-conducteur opto-électronique (2),

b) un substrat de matériau isolant (3) sur la surface supérieure duquel le corps semi-conducteur (2) est disposé en relief,

c) deux connexions (4, 5) placées en couche mince sur la surface supérieure du substrat (3) et dont l'une est reliée à la surface inférieure du corps semi-conducteur (2), tandis que l'autre est reliée par un fil de liaison (7) à la surface supérieure du corps semi-conducteur (2), les deux connexions étant en liaison avec des éléments de contact (4a, 5a) situés sur la surface inférieure du substrat (3),

d) une couche transparente ou translucide (8) disposée au-dessus du corps semi-conducteur (2),

caractérisé par les particularités suivantes :

e) le substrat (3) est en matériau céramique ;

f) les deux connexions (4, 5) se prolongent de la surface supérieure jusque sur la surface inférieure du substrat (3) en passant par-dessus les deux côtés extrêmes de ce dernier et y forment les éléments de contact (4a, 5a) appliqués contre la surface inférieure du substrat sur laquelle elles constituent des surfaces de contact ;

g) la couche transparente ou translucide (8), qui est en résine époxy, est placée de manière à présenter une convexité en forme de dôme sur le côté large du substrat (3) qui supporte le corps semi-conducteur (2).

2. Composant selon la revendication 1, caractérisé en ce que le substrat sensiblement parallélépipédique (3) a une largeur maximale de 1,27 mm.

3. Composant selon la revendication 2, caractérisé en ce que le substrat (3) a une longueur de 3,2 mm, une largeur de 1,27 mm et une hauteur de 0,6 mm.

4. Composant selon la revendication 1, caractérisé en ce que la couche transparente ou translucide (8) recouvre la totalité du côté large du substrat (3) qui supporte le corps semi-conducteur (2).

5. Composant selon la revendication 1, caractérisé en ce que la couche transparente ou translucide (8) est colorée.

6. Composant selon la revendication 1, caractérisé en ce que la couche transparente ou translucide (8) a des propriétés de dispersion de la lumière.

7. Composant selon la revendication 1, caractérisé en ce que les deux connexions (4, 5) ont des longueurs différentes.

8. Composant selon la revendication 1, caractérisé en ce que le substrat (3) comporte sur les deux côtés extrêmes des dentelures par lesquelles les connexions (4, 5) passent de sa surface supérieure à sa surface inférieure.

FIG.1

FIG.2

0 083 627

FIG.5

22
20
21
1

FIG.4

16
17
18
19
1

FIG.3

12
12b 12a
11
15
1a
15
13
14

2

*FIG. 6.*